# EUROPEAN PATENT APPLICATION

(11) **EP 4 625 792 A1**
(43) Date of publication of application: **01.10.2025**
(21) Application number: 25164229.4
(22) Date of filing: 17.03.2025
(51) Int. Cl.: H02M 1/12, H02M 1/32, H02M 7/00, H02M 7/44, G01R 27/18

(54) **INVERTER DEVICE, ELECTRIC POWER ASSEMBLY SYSTEM AND VEHICLE**

(30) Priority: 28.03.2024 CN 202410378488
(71) Applicant: Valeo eAutomotive Shenzhen Co., Ltd, Shenzhen Guangdong 518128 (CN)
(72) Inventor: LIU, Ping, Shenzhen, 518128 (CN); GONG, Qingyu, Shenzhen, 518128 (CN); YAN, Yi, Shenzhen, 518128 (CN); LI, Zhongzhong, Shenzhen, 518128 (CN)
(74) Representative: Valeo Powertrain Systems

(57) **Abstract**

An inverter device, an electric power assembly system and a vehicle are disclosed. The inverter device is configured to invert input DC and output single-phase AC, and the inverter device includes: safety capacitors, including a first safety capacitor arranged between a live wire output end and a ground wire of the single-phase AC, and a second safety capacitor arranged between a neutral wire output end and the ground wire of the single-phase AC, the first safety capacitor being identical to the second safety capacitor; wherein each of the first safety capacitor and the second safety capacitor is formed of a first sub-capacitor and a second sub-capacitor.

## Description

### Technical Field

The present invention relates to the field of electric power control, and more specifically to an inverter device, an electric power assembly system and a vehicle.

### Background Art

As the use of inverter devices becomes widespread in the civil and commercial fields, stricter requirements are being imposed on their configuration.

Existing inverter devices are intended to realize the process of inverting input DC and outputting single-phase AC, and generally comprise safety capacitors arranged between a live wire output end and a ground wire, and between a neutral wire output end and the ground wire, of the single-phase AC; such safety capacitors are intended to suppress common-mode interference with the power grid. However, existing safety capacitors are generally formed of a single type of capacitor, e.g. of a multi-layer ceramic capacitor alone, or a film capacitor alone. As a result, when an inverter device undergoes insulation impedance measurement, due to the principles of such impedance measurement, the voltage measured in the process of impedance measurement is associated with the voltage present on the safety capacitor. As existing safety capacitors are formed of only a single type of capacitor, the high capacitor leakage current causes the impedance of the safety capacitor to drift in the process of impedance measurement, so the acquired measurement voltage is unstable. This affects the precision of inverter impedance measurement, and incorrect impedance measurement results might even be obtained.

For this reason, it is necessary to be able to effectively reduce leakage current from a safety capacitor in an inverter device and reduce safety capacitor impedance drift while realizing good inversion functionality in the inverter device, so as to improve the precision and reliability of inverter impedance measurement.

### Summary of the Invention

In response to the above problem, the present invention provides an inverter device, an electric power assembly system and a vehicle. Using the inverter device provided in the present invention, it is possible to reduce leakage current from safety capacitors in the inverter device, reduce safety capacitor impedance drift, and increase the precision and reliability of the inverter impedance measurement process, while realizing the process of inverting DC to AC effectively.

According to one aspect of the present invention, an inverter device is proposed, wherein the inverter device is configured to invert input DC and output single-phase AC, and the inverter device comprises: safety capacitors, comprising a first safety capacitor arranged between a live wire output end and a ground wire of the single-phase AC, and a second safety capacitor arranged between a neutral wire output end and the ground wire of the single-phase AC, the first safety capacitor being identical to the second safety capacitor, wherein each of the first safety capacitor and the second safety capacitor is formed of a first sub-capacitor and a second sub-capacitor.

In some embodiments, the first sub-capacitor is a multi-layer ceramic capacitor.

In some embodiments, the second sub-capacitor is a film capacitor.

In some embodiments, the first sub-capacitor and the second sub-capacitor are connected in parallel.

In some embodiments, the first sub-capacitor and the second sub-capacitor are connected in series.

In some embodiments, each of the first safety capacitor and the second safety capacitor comprises a film capacitor and a multi-layer ceramic capacitor.

In some embodiments, for each of the first safety capacitor and the second safety capacitor, the capacitance of the multi-layer ceramic capacitor is less than 25nF, the capacitance of the film capacitor is less than 25nF, and the total capacitance of the multi-layer ceramic capacitor and the film capacitor is less than 50nF.

In some embodiments, the inverter device further comprises an insulation impedance measurement circuit, which is configured to measure a performance state of insulation impedance between the live wire output end and the ground wire, and between the neutral wire output end and the ground wire.

In some embodiments, the insulation impedance measurement circuit comprises: a sampling sub-circuit, configured to sample voltage signals between the live wire output end and the ground wire, and between the neutral wire output end and the ground wire, to obtain AC sampled signals; a precision rectification sub-circuit, configured to convert the AC sampled signals to DC signals; a low-pass filtering sub-circuit, configured to filter the DC signals to obtain DC filtered signals; a central processing sub-circuit, configured to determine a performance state of insulation impedance in the inverter device on the basis of the DC filtered signals from between the live wire output end and the ground wire and between the neutral wire output end and the ground wire.

In some embodiments, the central processing sub-circuit is configured to: calculate a signal difference of the DC filtered signals between the live wire output end and the ground wire and between the neutral wire output end and the ground wire; compare the signal difference with a preset difference range, and determine a performance state of insulation impedance in the inverter device on the basis of a comparison result.

According to another aspect of the present disclosure, an electric power assembly system is proposed, comprising an inverter device as described above.

According to another aspect of the present disclosure, a vehicle is proposed, comprising an electric power assembly system as described above.

### Brief Description of the Drawings

In order to describe the technical solution of embodiments of the present invention more clearly, the drawings required to be used in describing the embodiments will be briefly described below. Obviously, the drawings described below show only some embodiments of the present invention, and for those of ordinary skill in the art, other drawings can be obtained according to these drawings without inventive effort. The drawings below have not been drawn meticulously in proportion according to actual dimensions, but focus on showing the substance of the present invention.
Fig. 1 is a schematic drawing of an inverter device 100 according to an embodiment of the present disclosure.
Fig. 2 is a schematic drawing of the principles of insulation impedance measurement of an inverter device according to an embodiment of the present disclosure.
Fig. 3 is a schematic drawing of sub-capacitors connected in parallel according to an embodiment of the present disclosure.
Fig. 4 is a schematic drawing of sub-capacitors connected in series according to an embodiment of the present disclosure.
Fig. 5 is a schematic drawing of an insulation impedance measurement circuit 200 according to an embodiment of the present disclosure.
Fig. 6 is a schematic chart of voltage digital quantities of measurement voltages obtained by insulation impedance measurement according to an embodiment of the present disclosure.

### Detailed Description of the Invention

The technical solution in embodiments of the present invention will be described clearly and completely below with reference to the drawings. Obviously, the embodiments described are merely some, not all, of the embodiments of the present invention. All other embodiments obtained by those skilled in the art based on embodiments of the present invention without inventive effort shall also fall within the scope of protection of the present invention.

As indicated in the present application and claims, unless expressly specified otherwise in the context, words such as "a", "one", "one type", and/or "said" do not specifically mean the singular, and may also include the plural. Generally, the terms "comprise" and "include" only indicate the inclusion of expressly identified steps and elements, but these steps and elements do not constitute an exclusive list, and a method or device may also include other steps or elements.

Although the present application makes various references to certain modules in the system according to embodiments of the present application, any number of different modules may be used and run on user terminals and/or servers. The modules are purely illustrative, and different modules may be used in different aspects of the system and the method.

In the present application, a flowchart is used to explain operations performed by a system according to an embodiment of the present application. It should be understood that the preceding or subsequent operations are not necessarily performed in a precise sequence. On the contrary, based on needs, various steps may be performed in reverse sequence or at the same time. In addition, other operations may also be added to these processes, or one or more steps may be removed from these processes.

It should be understood that existing inverter devices are intended to realize the process of inverting input DC and outputting single-phase AC, and generally comprise safety capacitors arranged between a live wire output end and a ground wire, and between a neutral wire output end and the ground wire, of the single-phase AC; such safety capacitors are intended to suppress common-mode interference with the power grid. However, existing safety capacitors are generally formed of a single type of capacitor, e.g. of a multi-layer ceramic capacitor alone, or a film capacitor alone. As a result, when an inverter device undergoes insulation impedance measurement, due to the principles of such impedance measurement, the voltage measured in the process of impedance measurement is associated with the voltage present on the safety capacitor (the specific association is explained below in conjunction with an impedance measurement circuit and impedance measurement principles). As existing safety capacitors are formed of only a single type of capacitor, the high capacitor leakage current causes the impedance of the safety capacitor to drift in the process of impedance measurement, so the acquired measurement voltage is unstable. This affects the precision of inverter impedance measurement, and incorrect impedance measurement results might even be obtained.

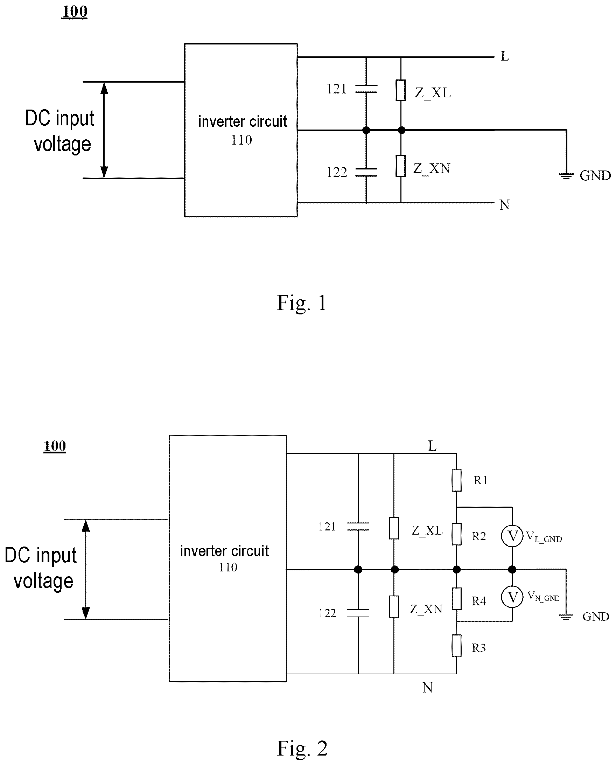

Based on the above, according to one aspect of the present disclosure, an inverter device 100 is proposed. The inverter device 100 is configured to invert input DC and output single-phase AC. Fig. 1 shows a schematic drawing of an inverter device 100 according to an embodiment of the present disclosure.

Referring to Fig. 1, for example, the inverter device for example comprises an inverter circuit 110 for converting DC to AC, which may for example be a single-phase full-bridge inverting circuit or a single-phase half-bridge inverting circuit. It should be understood that embodiments of the present disclosure are not restricted with regard to the inverting circuit of the inverter or the specific way in which inversion is realized.

The inverter device 100 further comprises: safety capacitors, comprising a first safety capacitor 121 arranged between a live wire output end L and a ground wire GND of the single-phase AC, and a second safety capacitor 122 arranged between a neutral wire output end N and the ground wire GND of the single-phase AC, the first safety capacitor 121 being identical to the second safety capacitor 122.

It should be understood that the safety capacitor, also known as Y safety capacitor or Y capacitor, is a capacitor used to be connected between a phase wire (e.g. neutral wire or live wire) and a ground wire. It is used to filter out common-mode interference on a power line, thereby reducing the harm of lightning strikes and surges to equipment.

It should be understood that the inverter device for example further comprises an insulating material (for example having an equivalent insulation impedance Z_XL) arranged between the live wire output end L and the ground wire GND, and an insulating material (for example having an equivalent insulation impedance Z_XN) arranged between the neutral wire output end N and the ground wire GND of the single-phase AC, to achieve good insulation between the neutral wire, live wire and ground wire and prevent breakdown. It should be understood that embodiments of the present disclosure are not restricted with regard to the specific composition of the insulating material and the specific resistance of the corresponding insulation impedance.

In addition, for example in the process of performing insulation impedance measurement of the inverter device, the performance characteristics of the safety capacitors have a significant impact on the measurement result. The purpose of insulation impedance measurement of the inverter device is to check whether the degree of insulation inside the inverter device meets standard requirements, so as to ensure the safety of the inverter device in the course of long-term use.

Fig. 2 is a schematic drawing of the principles of insulation impedance measurement of an inverter device according to an embodiment of the present disclosure.

Referring to Fig. 2, when performing insulation impedance measurement of the inverter device, for example, a live wire measurement voltage V_{L_GND} capable of reflecting a voltage value between the live wire output end L and the ground wire GND will be acquired, a neutral wire measurement voltage V_{N_GND} capable of reflecting a voltage value between the neutral wire output end N and the ground wire GND will be acquired, and a differential operation will be performed on the basis of the live wire measurement voltage and the neutral wire measurement voltage, so as to determine the insulation impedance of the inverter device. Specifically, as shown in Fig. 2, for example, a voltage between the live wire output end L and the ground wire GND can be divided through a resistor R1 and a resistor R2, and a voltage across the resistor R2 can be measured to serve as the live wire measurement voltage V_{L_GND}; and a voltage between the neutral wire output end N and the ground wire GND of the single-phase AC can be divided through a resistor R3 and a resistor R4, and a voltage across the resistor R4 can be measured to serve as the neutral wire measurement voltage V_{N_GND}.

For example, if the insulation impedance of the inverter device is normal, the live wire measurement voltage and neutral wire measurement voltage should be substantially equal; if the insulation impedance of the inverter device is abnormal, for example when insulating material between the live wire output end L and the ground wire GND is damaged or has been broken down, the difference between the live wire measurement voltage and the neutral wire measurement voltage will increase significantly, so it can be determined that there is abnormality of insulation impedance.

As stated above, the live wire measurement voltage V_{L_GND} acquired is significantly affected by capacitor impedance of the first safety capacitor 121 arranged between the live wire output end L and the ground wire GND, and the neutral wire measurement voltage V_{N_GND} acquired is significantly affected by capacitor impedance of the second safety capacitor 122 arranged between the neutral wire output end N and the ground wire GND of the single-phase AC.

Each of the first safety capacitor and the second safety capacitor is formed of a first sub-capacitor and a second sub-capacitor.

It should be understood that the first sub-capacitor and the second sub-capacitor are two different types of capacitors. For example, the first sub-capacitor may be a ceramic capacitor, while the second sub-capacitor is a film capacitor, different from the ceramic capacitor. It should be understood that embodiments of the present disclosure are not limited with regard to the specific types of the first and second sub-capacitors.

Based on the above, in the present application, the inverter device is configured to comprise the first safety capacitor arranged between the live wire output end and the ground wire of the single-phase AC, and the second safety capacitor identical to the first safety capacitor and arranged between the neutral wire output end and the ground wire of the single-phase AC, and each of the first safety capacitor and the second safety capacitor is configured to be formed of a first sub-capacitor and a second sub-capacitor; compared with the existing situation whereby a safety capacitor is formed by only a single capacitor (e.g. formed of a multi-layer ceramic capacitor alone or a film capacitor alone), the configuration whereby different sub-capacitors (first and second sub-capacitors) together form the safety capacitor makes it possible to assimilate the characteristics of capacitors of different types effectively and make up for the deficiency in performance of a single capacitor. It is thus possible to advantageously mitigate the undesirable situation whereby safety capacitors have high leakage current and high amplitude of impedance drift at the present time. The performance of the safety capacitors in impedance measurement of the inverter device is further considered and taken into account while taking into account the common-mode suppression functionality of the safety capacitors, so that the precision and reliability of inverter device impedance measurement can be improved while realizing good inversion functionality.

In some embodiments, the first sub-capacitor C1 is a multi-layer ceramic capacitor.

In a multi-layer ceramic capacitor (MLCC), ceramic dielectric film sheets printed with electrodes (internal electrodes) are stacked in an offset manner, and subjected to an one time high-temperature sintering operation to form a ceramic chip; metal layers (outer electrodes) are then used to seal two ends of the chip, thereby forming a structure similar to a monolith. For this reason, it is also called a monolithic capacitor.

The MLCC for example has the following characteristics: firstly, due to the use of the structure in which multiple dielectric layers are stacked, inductance is very low at high frequencies, the capacitor has very low equivalent series resistance, and impedance is low. Secondly, upon breakdown, the capacitor will not burn or explode, so safety is high.

Based on the above, in the present application, as a result of configuring the first sub-capacitor to be an MLCC, the safety capacitor formed is able to effectively assimilate the good capacitive characteristics of the MLCC; and while realizing good inversion performance of the inverter device, leakage current from the safety capacitor is reduced effectively, and impedance drift is reduced.

In some embodiments, the second sub-capacitor C2 is a film capacitor.

The film capacitor, also called a plastic film capacitor, uses metal foil as electrodes, and uses plastic film such as polyethylene, polypropylene, polystyrene or polycarbonate which is overlapped from two ends and wound into a cylindrical structure.

Depending on the type of plastic film, these are also known as polyethylene capacitors (or polyester capacitors), polypropylene capacitors (or PP capacitors), polystyrene capacitors (or PS capacitors) and polycarbonate capacitors. It should be understood that embodiments of the present disclosure are not limited with regard to the specific type of the film capacitor.

The film capacitor for example has the following characteristics: firstly, the film capacitor has extremely high precision, so can meet the precision requirements of various applications. Its manufacturing process is highly precise, so is able to produce a capacitor with small tolerances and good stability. Secondly, the film capacitor has stable capacitance, with better stability than that of ceramic capacitors and aluminium electrolytic capacitors. Moreover, the film capacitor has low temperature drift, so will not experience significant variation in capacitance due to temperature variation. Thirdly, the film capacitor has a small size and light weight, so is suitable for the manufacture of a miniaturized product. In addition, the film capacitor has a long service life, which can reach several decades or even longer with correct use. In addition, the film capacitor has strong resistance to interference from vibration and shocks, being able to operate normally even in harsh environments.

Based on the above, in the present application, as a result of configuring the second sub-capacitor to be a film capacitor, the safety capacitor formed is able to effectively assimilate the good capacitive characteristics of the film capacitor; and while realizing good inversion performance of the inverter device, leakage current from the safety capacitor is reduced effectively, and impedance drift is reduced.

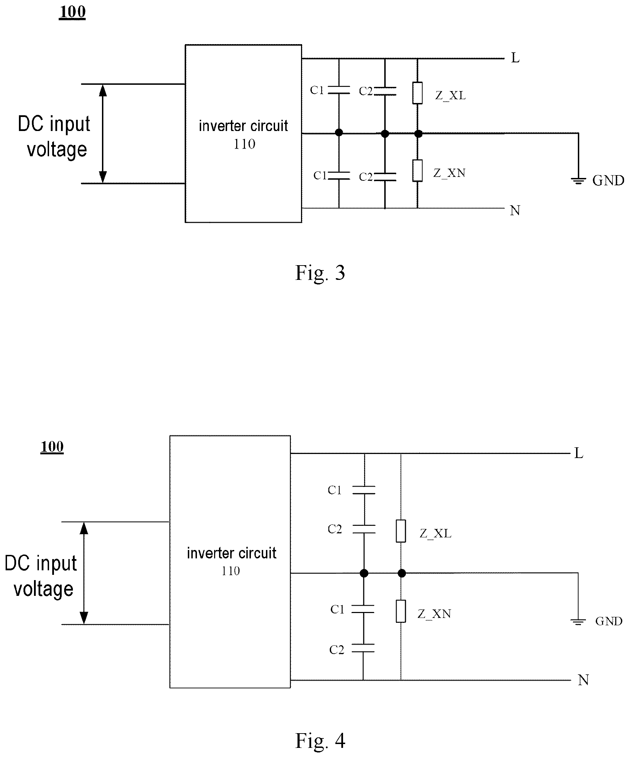

In some embodiments, the first sub-capacitor C1 and the second sub-capacitor C2 are connected in parallel. Fig. 3 is a schematic drawing of sub-capacitors connected in parallel according to an embodiment of the present disclosure.

Referring to Fig. 3, as a result of having the first sub-capacitor C1 and the second sub-capacitor C2 connected in parallel, on the one hand, the equivalent capacitance of the safety capacitor obtained (e.g. the first safety capacitor and the second safety capacitor) is the sum of the capacitance of the first sub-capacitor C1 and the capacitance of the second sub-capacitor C2, so the capacitance of the safety capacitor obtained is increased. On the other hand, as a result of connecting the first sub-capacitor C1 and the second sub-capacitor C2 in parallel to form the safety capacitor, the safety capacitor formed is able to assimilate and possess the favourable characteristics of the two different types of sub-capacitors; this helps to reduce leakage current from the safety capacitor and reduce impedance drift.

In some embodiments, the first sub-capacitor C1 and the second sub-capacitor C2 are connected in series. Fig. 4 is a schematic drawing of sub-capacitors connected in series according to an embodiment of the present disclosure.

Referring to Fig. 4, as a result of having the first sub-capacitor C1 and the second sub-capacitor C2 connected in series, on the one hand, the capacitance of the safety capacitor obtained (e.g. the first safety capacitor and the second safety capacitor) is the reciprocal of the sum of the reciprocal of the capacitance of the first sub-capacitor C1 and the reciprocal of the capacitance of the second sub-capacitor C2, so the capacitance of the safety capacitor obtained is reduced. On the other hand, as a result of connecting the first sub-capacitor C1 and the second sub-capacitor C2 in series to form the safety capacitor, the safety capacitor formed is able to assimilate and possess the favourable characteristics of the two different types of sub-capacitors; this helps to reduce leakage current from the safety capacitor and reduce impedance drift.

In some embodiments, each of the first safety capacitor and the second safety capacitor comprises a film capacitor and a multi-layer ceramic capacitor.

As a result of configuring each of the first safety capacitor and the second safety capacitor to comprise a film capacitor and an MLCC, the first safety capacitor is able to simultaneously assimilate and possess the favourable characteristics of the film capacitor and the MLCC mentioned above; this helps to reduce leakage current from the safety capacitor and reduce impedance drift. In addition, by flexibly configuring the way in which the capacitances of the film capacitor and the MLCC are combined, many aspects can be taken into account simultaneously, such as manufacturing costs, safety capacitor performance and precision of insulation impedance measurement.

In some embodiments, for each of the first safety capacitor 121 and the second safety capacitor 122, the capacitance of the MLCC is less than 25nF, the capacitance of the film capacitor is less than 25nF, and the total capacitance of the MLCC and the film capacitor is less than 50nF.

It should be understood that the total capacitance of the MLCC and the film capacitor will be calculated in different ways, depending on the connection relationship therebetween. For example, when the MLCC and the film capacitor are connected in parallel, the total capacitance of the MLCC and the film capacitor is the sum of the capacitance of the MLCC and the capacitance of the film capacitor. When the MLCC and the film capacitor are connected in series, the total capacitance of the MLCC and the film capacitor is the reciprocal of the sum of the reciprocals of all of the series-connected capacitances.

For example, depending on actual needs, an MLCC with a small capacitance may be provided, while a film capacitor with a large capacitance is used to reduce manufacturing costs (an MLCC has a high manufacturing cost, so choosing a small capacitance is better for reducing volume and costs).

For example, when the MLCC and the film capacitor are connected in parallel, the capacitance of the MLCC may be set to 4.7nF, and the capacitance of the film capacitor may be set to 8.2nF. When the MLCC and the film capacitor are connected in series, the capacitance of the MLCC may be set to 7.4nF, and the capacitance of the film capacitor may be set to 8.2nF. However, it should be understood that the above are merely setting examples of capacitances of the MLCC and the film capacitor. Embodiments of the present disclosure are not restricted with regard to the specific values of the capacitance of the MLCC and the capacitance of the film capacitor.

Based on the above, in the present application, as a result of configuring the total capacitance of the MLCC and the film capacitor to be less than 50nF, the value of touch current flowing through the safety capacitor is able to meet a preset standard requirement, e.g. less than 3.4mA (the Chinese national standard requires it to be less than 3.4mA); thus, the current flowing through the safety capacitor can be kept within a small range while ensuring that the safety capacitor can be used effectively, thus helping to improve the safety and reliability of the capacitor.

In some embodiments, the inverter device 100 further comprises an insulation impedance measurement circuit 200. The insulation impedance measurement circuit 200 is configured to measure a performance state of insulation impedance between the live wire output end L and the ground wire GND, and between the neutral wire output end N and the ground wire GND.

It should be understood that, as stated above, the insulation impedance is for example an equivalent impedance of corresponding insulating material. Specifically, the inverter device for example further comprises an insulating material (for example having an equivalent insulation impedance Z_XL) arranged between the live wire output end L and the ground wire GND, and an insulating material (for example having an equivalent insulation impedance Z_XN) arranged between the neutral wire output end N and the ground wire GND of the single-phase AC, to achieve good insulation between the neutral wire, live wire and ground wire and prevent breakdown. It should be understood that embodiments of the present disclosure are not restricted with regard to the specific composition of the insulating material or the specific resistance of the corresponding insulation impedance.

The performance state of the insulation impedance is intended to characterize the performance of the insulation impedance (i.e. the corresponding insulating material) at the present time, and for example comprises a normal performance state and an abnormal performance state. A normal performance state means that the insulation impedance is at a normal resistance, i.e. means that the insulating material corresponding to the insulation impedance is in a good insulation state. An abnormal performance state means that the insulation impedance is at a resistance level significantly lower than normal resistance, i.e. means that the insulating material corresponding to the insulation impedance is damaged, or there is leakage in the inverter device circuit.

It should be understood that, depending on actual needs, the insulation impedance measurement circuit may for example have different constituent subcircuits. Embodiments of the present disclosure are not restricted with regard to the specific composition of the insulation impedance measurement circuit.

It should be understood that, depending on actual needs, the insulation impedance measurement circuit may for example be a single-ended measurement circuit, i.e. is only able to perform proper measurement when the insulation impedance between the live wire output end L and the ground wire GND, or the insulation impedance between the neutral wire output end N and the ground wire GND, enters an abnormal performance state. However, it should be understood that embodiments of the present disclosure are not limited to this.

Based on the above, in the present application, as a result of configuring the inverter device to further comprise the insulation impedance measurement circuit 200, the insulation impedance measurement circuit 200 being configured to measure a performance state of insulation impedance between the live wire output end L and the ground wire GND, and between the neutral wire output end N and the ground wire GND, it is possible to reliably check the insulation impedance performance of the inverter device via the insulation impedance measurement circuit, making it easier to promptly discover insulation damage or leakage, and thus improving the reliability and safety of the inverter device.

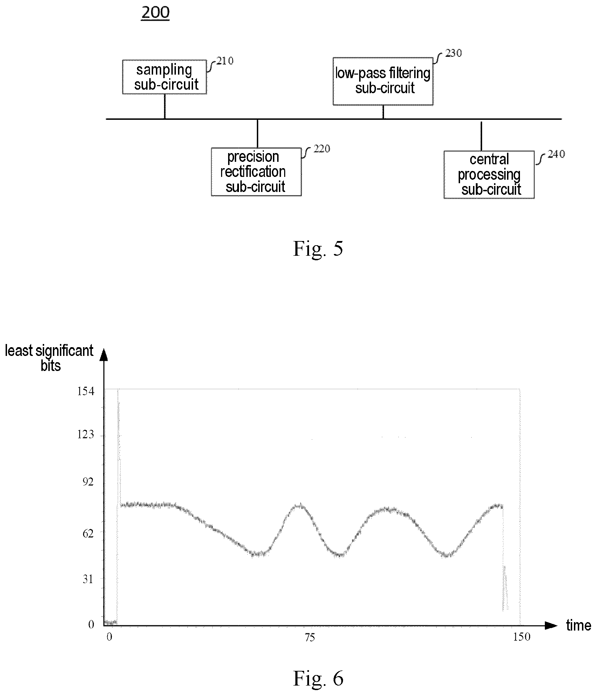

In some embodiments, the insulation impedance measurement circuit 200 may for example be described more specifically. Fig. 5 is a schematic drawing of the insulation impedance measurement circuit 200 according to an embodiment of the present disclosure.

Referring to Fig. 5, the insulation impedance measurement circuit 200 comprises: a sampling sub-circuit 210, a precision rectification sub-circuit 220, a low-pass filtering sub-circuit 230 and a central processing sub-circuit 240.

The sampling sub-circuit 210 is configured to sample voltage signals between the live wire output end L and the ground wire GND, and between the neutral wire output end N and the ground wire GND, to obtain AC sampled signals.

The AC sampled signals are AC voltage signals obtained by separately sampling the voltage signals between the live wire output end L and the ground wire GND, and between the neutral wire output end N and the ground wire GND.

It should be understood that this may for example be direct sampling of voltages between the live wire output end L and the ground wire GND and between the neutral wire output end N and the ground wire GND; alternatively, based on Fig. 2 mentioned above, the voltages between the live wire output end L and the ground wire GND and between the neutral wire output end N and the ground wire GND are divided through resistors, and voltages across some of the resistors are acquired, such that the acquired voltages are able to better reflect changes in insulation impedance, and such that the acquired voltage values can be much less than the voltages between the live wire output end L and the ground wire GND and between the neutral wire output end N and the ground wire GND. For example, the voltage value of the sampled voltage is set to be less than 5V, to facilitate further processing later.

However, it should be understood that only one example is given above; embodiments of the present disclosure are not restricted with regard to the specific sampling method of obtaining the AC sampled signals, and the voltage values of the AC sampled signals.

The precision rectification sub-circuit 220 is configured to convert the AC sampled signals to DC signals.

The precision rectification circuit is a circuit used to convert AC signals to highly precise DC signals, and depending on actual needs, may for example be a half-wave rectification circuit or a full-wave rectification circuit. Embodiments of the present disclosure are not restricted with regard to the specific composition of the precision rectification circuit.

The low-pass filtering sub-circuit 230 is configured to filter the DC signals to obtain DC filtered signals.

The low-pass filtering sub-circuit is a frequency selective circuit, which can be used to screen or reduce high-frequency signal components while transmitting or enhancing low-frequency signal components; that is, it causes low-frequency signal components in the input DC signals to be transmitted to an output end with low loss, and causes high-frequency signal components in the DC signals to be effectively suppressed.

The DC filtered signals are DC signals output after low-pass filtering; high-frequency signal components in the DC filtered signals are significantly reduced, while low-frequency signal components are retained effectively.

It should be understood that, depending on actual needs, the low-pass filtering sub-circuit may for example be an active filtering circuit (e.g. composed of an RC network and an integrated operational amplifier) or a passive filtering circuit. Embodiments of the present disclosure are not limited to this.

The central processing sub-circuit 240 is configured to determine a performance state of insulation impedance in the inverter device on the basis of the DC filtered signals from between the live wire output end L and the ground wire GND and between the neutral wire output end N and the ground wire GND.

It should be understood that the central processing sub-circuit may for example calculate a signal difference of the DC filtered signals between the live wire output end and the ground wire and between the neutral wire output end and the ground wire; compare the signal difference with a preset difference range, and determine a performance state of insulation impedance in the inverter device on the basis of a comparison result.

However, it should be understood that only one exemplary method of determining performance state is given above, and embodiments of the present disclosure are not limited to this.

Based on the above, in the present application, as a result of configuring the insulation impedance measurement circuit to comprise the sampling sub-circuit, the precision rectification sub-circuit, the low-pass filtering sub-circuit and the central processing sub-circuit, it is possible to effectively realize the process of checking the insulation of the inverter device based on the cooperation of the various subcircuits, so as to promptly and accurately ascertain the condition of the inverter device insulation and adopt appropriate measures.

In some embodiments, the central processing sub-circuit 240 is configured to: firstly, calculate a signal difference of the DC filtered signals between the live wire output end L and the ground wire GND and between the neutral wire output end N and the ground wire GND; and then compare the signal difference with a preset difference range, and determine a performance state of insulation impedance in the inverter device on the basis of a comparison result.

It should be understood that the signal difference may for example be the absolute value of the difference between the voltage value of the DC filtered signal of the voltage between the live wire output end L and the ground wire GND, and the voltage value of the DC filtered signal between the neutral wire output end N and the ground wire GND.

It should be understood that the preset difference range may for example be a reasonable difference range that is set in advance, and characterizes a range of differences between the voltage value of the DC filtered signal of the voltage between the live wire output end L and the ground wire GND, and the voltage value of the DC filtered signal between the neutral wire output end N and the ground wire GND, in normal circumstances; if the preset difference range is exceeded, this means that there is an abnormal impedance state.

The process of determining a performance state of insulation impedance in the inverter device on the basis of a comparison result may for example be described more specifically; for example, it is possible to judge whether the currently obtained signal difference falls within the preset difference range, and determine that the insulation impedance of the inverter device is in a normal performance state if the difference signal falls within the preset difference range; and determine that the insulation impedance of the inverter device is in an abnormal performance state if the difference signal does not fall within the preset difference range. Alternatively, it is also possible to subject the difference signal to further analysis, and judge whether it is the impedance between the live wire output end L and the ground wire GND which is in an abnormal performance state, or the impedance between the neutral wire output end N and the ground wire GND which is in an abnormal performance state.

It should be understood that the present disclosure is not restricted with regard to the process of judging the performance state or the specific way in which the judgement output result is expressed.

Based on the above, in the present application, as a result of configuring the central processing sub-circuit to calculate a signal difference of the DC filtered signals between the live wire output end and the ground wire and between the neutral wire output end and the ground wire, compare the signal difference with a preset difference range, and determine a performance state of insulation impedance in the inverter device on the basis of a comparison result, the performance state of insulation impedance in the inverter device can be judged effectively and reliably in a simple and convenient way.

The inverter device will be described in more specific terms with reference to a specific application scenario. For example, when the inverter device is subjected to insulation impedance measurement by means of the abovementioned insulation impedance measurement circuit 200 in accordance with the schematic drawing of the principles of insulation impedance measurement shown in Fig. 2, and when the first and second safety capacitors of the inverter device are configured to both comprise the MLCC and the film capacitor connected in parallel, and the capacitance of the MLCC is set at 4.7nF and the capacitance of the film capacitor is set at 8.2nF, Fig. 6 is a schematic chart of voltage digital quantities of measurement voltages obtained by insulation impedance measurement, wherein the horizontal coordinates are time (e.g. in units of ms), and the vertical coordinates are voltage digital quantity outputs obtained by conversion in an analog-to-digital converter (AD) of the central processing sub-circuit after sampling of voltage signals, in units of least significant bit (LSB), wherein the voltage digital quantities are proportional to the voltage values of the sampled voltages.

Referring to Fig. 6, it can be seen that at this time, the voltage across the measurement resistor (e.g. measurement resistor R2) is essentially stable, indicating that the capacitor voltage across the safety capacitor is essentially stable, and it can be seen that drift in the voltage digital quantity of this measurement resistor is within a range of less than 30 LSB; compared to an existing safety capacitor formed of only a single type of sub-capacitor (a measurement resistor of which generally has voltage digital quantity drift of more than a hundred LSB or several hundred LSB), there is a marked improvement in variation of the equivalent capacitive reactance of the safety capacitor.

According to another aspect of the present disclosure, an electric power assembly system is proposed, comprising an inverter device as described above, and capable of realizing the functionality described above, which is not repeated here.

According to another aspect of the present disclosure, a vehicle is proposed, comprising an electric power assembly system as described above, and having an inverter device as described above, capable of realizing the functionality described above.

For example, when in inverting mode (in which the vehicle acts as a charging power supply to charge an external device), the vehicle can use the inverter device in the electric power assembly system to realize effective and reliable external charging.

The program part of technology may be regarded as a "product" in the form of executable code and/or associated data, and is participated in or realized by means of a computer-readable medium. A tangible, permanent storage medium may comprise internal memory or memory used by any computer, processor, or similar device or associated module. Examples include various types of semiconductor memories, tape drives, disk drives or any similar devices capable of providing a storage function for software.

All software or part thereof might sometimes communicate via a network, such as the internet or another communication network. Communication of this type can load software from one computer device or processor to another. For example: software can be loaded from a host computer or a server of a target tracking device to a hardware platform of a computer environment, or another computer environment realizing a system, or a system of a similar function related to the provision of required information. Thus, another type of medium capable of transmitting software elements can also be used as a physical connection between local devices, e.g. light waves, electric waves, electromagnetic waves, etc., with propagation being realized through electric cables, optical fibres or air, etc. The physical medium used for carrying waves, such as an electric cable, wireless connection, optical fibre or similar equipment, can also be regarded as being a medium that carries software. Unless the usage herein limits tangible "storage" media, all other terms meaning computer- or machine-"readable media" mean media that participate in the process of execution of any instruction by a processor.

In the present application, specific words are used to describe the embodiments of the present application. For example, "first/second embodiment", "an embodiment", and/or "some embodiments" mean a certain feature, structure or characteristic related to at least one embodiment of the present application. Therefore, it should be emphasized and noted that "an embodiment" or "one embodiment" or "an alternative embodiment" mentioned twice or more in different places herein does not necessarily refer to the same embodiment. In addition, certain features, structures or characteristics in one or more embodiments of the present application may be appropriately combined.

Further, those of ordinary skill in the art may understand that various aspects of the present application may be explained and described by certain patentable types or situations, including a combination of any novel and useful procedures, machines, products, or substances, or any novel and useful improvements thereon. Accordingly, various aspects of the present application may be performed entirely by hardware, may be performed entirely by software (including firmware, resident software, microcode, etc.), and may also be performed by a combination of hardware and software. The above hardware or software may be referred to as "data block", "module", "engine", "unit", "component" or "system". In addition, aspects of this application might be manifested as a computer product, including computer-readable program code, located in one or more computer-readable media.

Unless otherwise defined, all terms (including technical and scientific terms) used herein have the same meaning as commonly understood by those of ordinary skill in the field to which the present invention belongs. It should also be understood that terms such as those defined in common dictionaries should be interpreted as having meanings consistent with their meanings in the context of the relevant art and should not be interpreted in an idealized or extremely formal sense unless explicitly defined as such herein.

A description of the present invention is given above, and should not be considered as a limitation thereof. Although several exemplary embodiments of the present invention have been described, those skilled in the art will readily appreciate that many modifications may be made to the exemplary embodiments without departing from the novel teachings and advantages of the present invention. Therefore, all such modifications are intended to be included within the scope of the present invention as defined in the claims. It should be understood that a description of the present invention is given above and should not be considered to be limited to the specific embodiments disclosed, and modifications to the disclosed embodiments and other embodiments are intended to be included within the scope of the appended claims. The present invention is defined by the claims and their equivalents.

## Claims

1. An inverter device, wherein the inverter device is configured to invert input DC and output single-phase AC, and the inverter device comprises:
safety capacitors, comprising a first safety capacitor arranged between a live wire output end and a ground wire of the single-phase AC, and a second safety capacitor arranged between a neutral wire output end and the ground wire of the single-phase AC, the first safety capacitor being identical to the second safety capacitor;
wherein each of the first safety capacitor and the second safety capacitor is formed of a first sub-capacitor and a second sub-capacitor.

2. The inverter device according to claim 1, wherein the first sub-capacitor is a multi-layer ceramic capacitor.

3. The inverter device according to claim 1 or 2, wherein the second sub-capacitor is a film capacitor.

4. The inverter device according to claim 1, wherein the first sub-capacitor and the second sub-capacitor are connected in parallel.

5. The inverter device according to claim 1, wherein the first sub-capacitor and the second sub-capacitor are connected in series.

6. The inverter device according to claim 1, wherein each of the first safety capacitor and the second safety capacitor comprises a film capacitor and a multi-layer ceramic capacitor.

7. The inverter device according to claim 6, wherein for each of the first safety capacitor and the second safety capacitor, the capacitance of the multi-layer ceramic capacitor is less than 25nF, the capacitance of the film capacitor is less than 25nF, and the total capacitance of the multi-layer ceramic capacitor and the film capacitor is less than 50nF.

8. The inverter device according to claim 1, wherein the inverter device further comprises an insulation impedance measurement circuit, the insulation impedance measurement circuit is configured to measure a performance state of insulation impedance between the live wire output end and the ground wire, and between the neutral wire output end and the ground wire.

9. The inverter device according to claim 8, wherein the insulation impedance measurement circuit comprises:
a sampling sub-circuit, configured to sample voltage signals between the live wire output end and the ground wire, and between the neutral wire output end and the ground wire, to obtain AC sampled signals;
a precision rectification sub-circuit, configured to convert the AC sampled signals to DC signals;
a low-pass filtering sub-circuit, configured to filter the DC signals to obtain DC filtered signals;
a central processing sub-circuit, configured to determine a performance state of insulation impedance in the inverter device on the basis of the DC filtered signals from between the live wire output end and the ground wire and between the neutral wire output end and the ground wire.

10. The inverter device according to claim 9, wherein the central processing sub-circuit is configured to:
calculate a signal difference of the DC filtered signals between the live wire output end and the ground wire and between the neutral wire output end and the ground wire;
compare the signal difference with a preset difference range, and determine a performance state of insulation impedance in the inverter device on the basis of a comparison result.

11. An electric power assembly system, comprising the inverter device according to any one of claims 1 - 10.

12. A vehicle, comprising the electric power assembly system according to claim 11.
